# EUROPEAN PATENT APPLICATION

(11) **EP 4 187 677 A1**
(43) Date of publication of application: **31.05.2023**
(21) Application number: 22205451.2
(22) Date of filing: 04.11.2022
(51) Int. Cl.: H01M 10/48, H01M 10/635, H02J 7/00

(54) **POWER CONTROL SYSTEM AND METHOD**

(30) Priority: 29.11.2021 US 202117536251
(71) Applicant: Transportation IP Holdings, LLC, Norwalk, CT 06851 (US)
(72) Inventor: NARCHAIL, Sakshi, 06851 Norwalk, CT (US); PRASANTH, Sunkara, 06851 Norwalk, CT (US); VERMA, Rajeev, Norwalk, CT, 06851 (US); SABARAD, Jayaprakash, 06851 Norwalk, CT (US); PIDURI, Tarunendra Sekhar, 06851 Norwalk, CT (US)
(74) Representative: Laufhütte, Dieter

(57) **Abstract**

A system and related method includes receiving an ambient temperature adjacent to a system, an electric current value of electricity that is conducted into or out of a battery coupled with the system, and a voltage of a battery circuit that includes the battery. An internal temperature of the battery is determined based at least in part on the ambient temperature, the current value, and the voltage. One or more conditions for charging or discharging the battery are determined based at least in part on the internal temperature of the battery, the current value, and the voltage. The battery is charged or discharged based on least on the one or more conditions.

## Description

### BACKGROUND

### Technical Field.

The subject matter described herein relates to a system and related method for determining a battery temperature of a power control system.

### Discussion of Art.

Batteries or other rechargeable power devices may be used within various systems to power propulsion and non-propulsion loads of the systems. As one example, a battery may be used within a vehicle to provide power to various components or systems of the vehicle. The recharging and/or discharging of the battery plays a role in the optimization of the life of the battery. For example, the life of the battery may be impacted by the battery being charged or discharged too quickly or too slowly, by the charging current value of the electricity directed to or from the battery during charging or discharging, by the charging voltage value, etc. The charging and discharging conditions for the battery may be considered in order to improve the life of the battery.

Additionally, the operating temperature of the battery may impact the life of the battery. For example, an age or lifespan of the battery may be dependent on the battery operating temperatures. In order to determine the optimal charging and/or recharging conditions for the battery to optimize the lifespan of the battery, the operating temperature of the battery must be considered. However, many systems do not include battery temperature sensors. For example, existing systems may be assembled or fabricated without including a battery temperature sensor, systems may not have the space or capacity to include a battery temperature sensor, or the like.

A need may exist for a system and method to determine charging and discharging conditions of a battery to improve the life of the battery without the use or presence of a battery temperature sensor.

### BRIEF DESCRIPTION

In one or more embodiments, a method includes receiving an ambient temperature adjacent to a system, an electric current value of electricity that is conducted into or out of a battery coupled with the system, and a voltage of a battery circuit that includes the battery. An internal temperature of the battery is determined based at least in part on the ambient temperature, the current value, and the voltage. One or more conditions for at least one of charging or discharging the battery are determined based at least in part on the internal temperature of the battery, the current value, and the voltage. The battery is at least one of charged or discharged based on least on the one or more conditions.

In one or more embodiments of the subject matter described herein, a power control system includes a controller that includes one or more processors configured to receive an ambient temperature via a temperature sensor, an electric current value of electricity that is conducted into or out of a battery via a current sensor, and a voltage of a battery circuit that includes the battery via a voltage sensor. The processors may determine an internal temperature of the battery based on at least in part on the ambient temperature, the current value, and the voltage. The processors may determine one or more conditions for at least one of charging or discharging the battery based at least in part on the internal temperature of the battery, the current value, and the voltage. The processors may control the at least one of the charging or discharging of the battery based on the one or more conditions.

In one or more embodiments, a method includes receiving an ambient temperature of a system, an electric current value of electricity that is conducted into or out of a battery coupled with the system, and a voltage of the battery. An internal temperature of the battery may be determined without a battery temperature sensor. The internal temperature of the battery may be determined based at least in part on the ambient temperature, the current value, and the voltage. One or more conditions for charging the battery may be determined based at least in part on the internal temperature of the battery, the current value, and the voltage. The one or more conditions may include one or more of a charging current or a charging voltage of the battery. The one or more conditions may control a rate of charging of the battery. The battery is automatically charged based on the one or more conditions. It may be determined that the internal temperature of the battery exceeds a designated absolute threshold value, and an alert may be communicated to an operator of the system based on the internal temperature of the battery exceeding the designated absolute threshold value. One or more of the conditions for charging the battery may be changed based on the internal temperature of the battery exceeding the designated absolute threshold value.

### BRIEF DESCRIPTION OF THE DRAWINGS

The inventive subject matter may be understood from reading the following description of non-limiting embodiments, with reference to the attached drawings, wherein below:
Figure 1 illustrates one example of a power system in accordance with one embodiment;
Figure 2 illustrates a flowchart of one example of a charging or discharging a battery of a power system in accordance with one embodiment; and
Figure 3 illustrates one example of a schematic of the flowchart shown in Figure 2 for charging or discharging the battery of a power system in accordance with one embodiment.

### DETAILED DESCRIPTION

Embodiments of the subject matter described herein relate to a system and method for determining a temperature of a battery in the absence of a battery temperature sensor. A power control system (e.g., a stationary or mobile system) may include a rechargeable power device, such as a battery, a resistor grid, a bank of batteries, or the like, that may provide power to loads of the power control system or other power control systems. The system may include a controller that receives an ambient temperature adjacent to the system, an electric current value of the electricity that is conducted into or out of the battery, and a voltage of the battery. The processors may use the ambient temperature, the current value, and the voltage to determine an internal temperature of the battery. For example, the internal temperature of the battery may be determined in the absence of or without a battery temperature sensor.

The processors may use the determined internal temperature of the battery, the current value, and the voltage of the battery to determine conditions for charging and/or discharging of the battery. The conditions may include a charging current value for electricity conducted into or out of the battery during charging or discharging. Optionally, the conditions may include a charging voltage value indicative of a voltage of the electricity directed into or out of the battery. The battery may be automatically charged and/or discharged based at least in part on the determined conditions. Additionally, the rate of charging or discharging the battery may be controlled based at least in part on the conditions for charging and/or discharging.

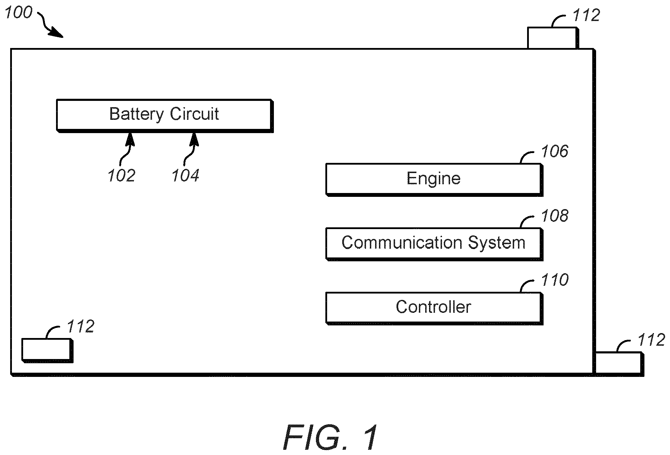

Figure 1 illustrates one example of a power control system 100 in accordance with one embodiment. In one embodiment, the power control system may be a mobile power control system such as a vehicle, such as a rail vehicle, an automobile, a truck, a bus, a mining vehicle, a marine vessel, an aircraft (manned or unmanned, such as a drone), an agricultural vehicle, industrial equipment, or other off-highway vehicle. In another embodiment, the power control system may be a stationary or non-moving power control system such as a wind-powered turbine, manufacturing machinery, power generating systems, or the like.

The power control system may include a communication system 108 that may communicate with components of the power control system and/or communicate with systems separate from the power control system. The communication system represents transceiving circuitry, one or more antennas, modems, or the like. In one or more embodiments, the communication system may receive and provide data signals to a controller 110 of the power control system, to one or more wayside devices, to one or more systems onboard another power control system, or the like. In one embodiment, the power control system may communicate wirelessly with another system, database, controller, or the like. Optionally, the power control system may communicate with other power systems, databases, controllers, wayside devices, or the like, via conductive pathways such as wires, cables, buses, or the like.

The power control system may include an engine 106 that or one or more other components that provides power to one or more components or systems of the power control system (e.g., engines, motors, generators, or the like). In one embodiment, the engine may provide propulsive power to propel a mobile power system to move along a route. In another embodiment, the engine may provide power to components or systems of a stationary power control system.

The power control system includes a battery circuit 102 that represents a source of electric energy that may be used to power one or more systems or components of the power control system. The battery circuit may include one or more batteries, battery cells, or other rechargeable electric energy storage device, wires or other conductive materials, or the like, which may be held or contained within a battery housing 104. In one or more embodiments, the battery of the battery circuit may be and/or represent a lead acid battery, a nickel cadmium battery, a nickel metal hydride battery, a lithium ion battery, or the like. In one or more embodiments, the battery circuit may include one or more batteries disposed therein the battery housing, or optionally the power control system may include two or more battery circuits having one or more battery cells that may be used to power the components of the power control system. The battery circuit may be a rechargeable battery such that the battery may receive electric energy from another power source (e.g., a traction motor of the power control system, an external power source such as a charging station or catenary line, from another power control system, or the like).

The power control system may include one or more sensors 112 disposed at different positions or locations within or external to the power control system. In one embodiment, one or more of the sensors may represent a temperature or thermal sensor that may sense or detect an ambient temperature at one or more locations adjacent to and/or outside of the power control system, surface temperatures of one or more components or systems of the power control system, or the like. In one or more embodiments, one or more of the sensors may detect or sense characteristics of the battery. For example, a current sensor may detect, sense, or otherwise measure an electric current value of electricity that is conducted into and/or out of the battery circuit. As another example, a voltage sensor may detect, sense, or otherwise measure a voltage of the battery circuit. As another example, a motion sensor may detect or sense a speed at which an axle of the power control system is rotating, or may detect a speed at which the power control system is moving. As another example, a pressure sensor may detect or identify fluid pressures within the power control system (e.g., brake fluid, compressor fluid pressure, or the like).

The power system may include a controller 110 that may represent a control module, and can include one or more processors, microcontrollers, or other logic-based devices and/or associated software or instructions, for carrying out one or more operations described herein. The controller controls operations of the power control system, such as by controlling tractive efforts and/or braking efforts provided by an engine and/or a braking system (not shown). The controller may be manually operated by receiving instruction signals from an input device (not shown) (e.g., a device that receives input from an operator such as, but not limited to, a touchscreen, a joystick, a keyboard, a switch, a wheel, a microphone, or the like) based on manually input from an operator at the input device. An output device (not shown) can provide information to the operator, such as operating conditions or settings of the power control system, power output information, battery circuit information (e.g., an electric current value of the battery circuit, a voltage of the battery circuit, an ambient temperature of the power control system, or the like), or the like.

The battery circuit may be used for one or more applications of the power control system such as, but not limited to, cranking, proving power for electronic panels and control systems, providing power for to or other auxiliary loads such as lighting, or the like. The state of charge of the battery changes responsive to the various applications of the power control system drawing electric energy from the battery. In one or more embodiments, the battery of the battery circuit may be required to be charged or discharged (e.g., electric energy may need to be removed from the battery circuit). One or more conditions of the battery and/or power control system may be considered in order to determine an optimal time for charging and/or discharging of the battery. For example, a battery charging voltage may be based at least in part on a temperature of the battery (e.g., an internal temperature). Additionally or alternatively, the battery age of the power control system may be dependent on the battery operating temperature (e.g., the internal temperature the battery reaches while the battery and/or the power control system is operating).

In one or more embodiments, conditions for charging and/or discharging of the battery may be based on one or more characteristics such as a time or frequency to recharge the battery (e.g., responsive to the battery reaching a determined state-of-charge, based on a determined amount of electric energy the power control system may require, based on a length of time the battery may have been or will be in use or operation, or the like), a rate at which the battery may receive electric energy for charging and/or a rate at which the battery may discharge electric energy, a total amount of electric energy the battery is capable of receiving, or the like.

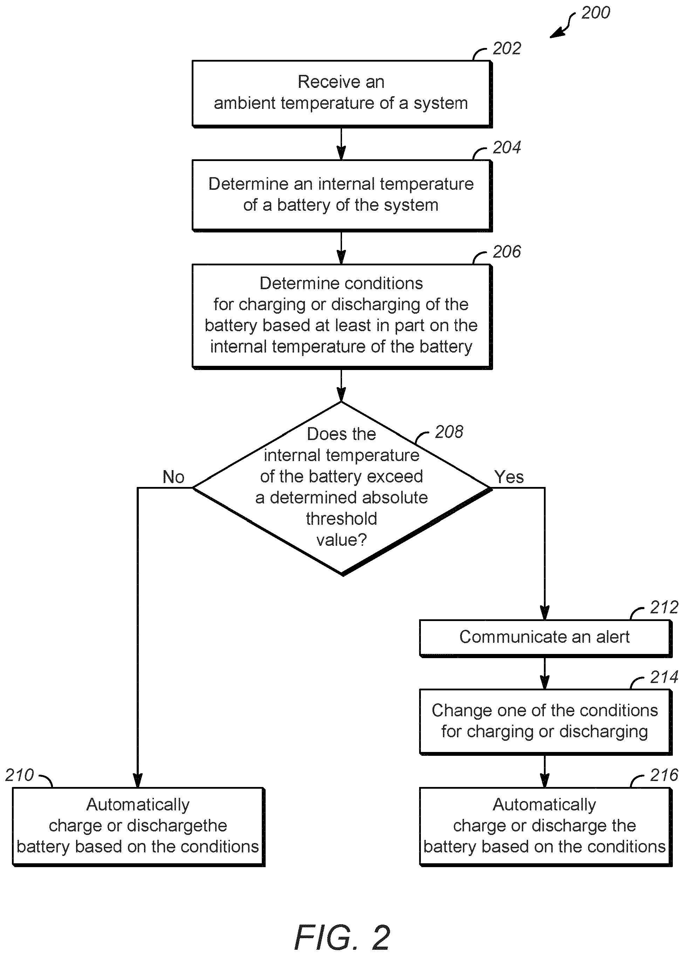

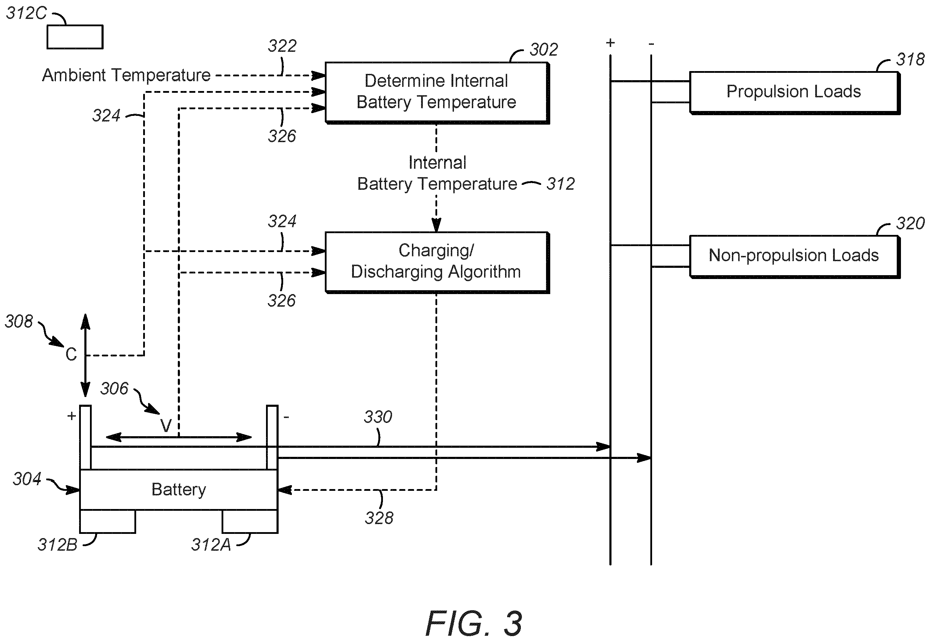

Figure 2 illustrates one example of a flowchart 200 of a method of charging or discharging a battery of a power system in accordance with one embodiment. Additionally, Figure 3 illustrates a schematic of the flowchart shown in Figure 2 for charging or discharging the battery of a power system in accordance with one embodiment. Figures 2 and 3 will be discussed together herein. The steps of the method can be completed by the controller of the power control system and/or by an alternative controller off-board or separate from the power control system. Optionally, the steps of the method may be completed in an alternative order, one or more steps may be eliminated, or one or more steps may be included.

At step 202, the one or more processors of the controller may receive an ambient temperature 322, such as from a sensor 312C of the power control system. The ambient temperature may be taken from a sensor outside of the power control system, within the power control system, at a location outside of and adjacent to the power control system, or the like. Optionally, the one or more processors may also receive one or more other ambient conditions (e.g., humidity, air quality, noise, or the like). Optionally, the one or more processors may also receive and/or have information related to geographic conditions of the power control system (e.g., a geospatial location of the power control system, a moving speed of a mobile power control system, or the like).

At step 204, the processors may determine an internal temperature 302 of a battery 304 of the battery circuit of the power control system. The calculated or determined internal temperature of the battery may be based on one or more of the ambient temperature 322 (such as received from a temperature sensor 312C), an electric current value 324 of electricity that is conducted into or out of the battery of the system (e.g., that may be received from a current sensor 312B), and a voltage 326 of the battery of the battery (e.g., that may be received from a voltage sensor 312A). Optionally, a single sensor may detect or sense multiple characteristics of the battery including the current value and the voltage. The internal temperature of the battery may be determined in the absence of or without a battery temperature sensor. For example, the internal temperature of the battery may be determined based on the ambient temperature adjacent to the power control system, the current value, and the voltage of the battery, and without the use of a battery temperature sensor. The determined internal temperature of the battery may be an estimated internal temperature, e.g., an approximation of the internal temperature determined without sensor data from a sensor that is located inside or extends inside the battery housing to measure the battery temperature internally.

In one or more embodiments, the internal or core temperature of the battery may be determined based on an operating mode of the battery. For example, in a bulk charging mode, the internal battery temperature is a majority function of the battery current value, and a minority function of the battery voltage. Alternatively, in a float battery mode, the internal battery temperature is a majority function of the battery voltage and a minority function of the battery current. For example, the current value of the electricity going into or out of the battery that is operating in float mode may be about zero. In one or more embodiments, the current value may include energy going into and/or out of the battery and battery losses (e.g., copper losses, or the like). In one embodiment, the voltage of the battery may include the battery voltage value and discharge losses of the battery while the battery operates in a float mode. The processors may determine the internal or core battery temperature based on the calculated energy of the battery, losses of the battery, thermal capacity coefficients and/or thermal resistance coefficients of the battery based on the type or modality of the battery, the age of the battery, the time of usage of the battery, or the like.

At step 206, the processors may determine one or more conditions for charging and/or discharging the battery. The conditions may be determined based on the current value 324, the voltage 326, and the determined (e.g., estimated) internal battery temperature 302. For example, an algorithm may associate or correlate the current value of the electricity conducted into or out of the battery with the voltage of the battery and the estimated internal temperature of the battery to determine conditions or characteristics for charging and/or discharging of the battery. The conditions or characteristics may include a charging current value of electric energy directed into or out of the battery, a charging or discharging voltage, a charging rate or speed, an amount of charge the battery can receive and/or discharge, a time for charging and/or discharging, a frequency for charging and/or discharging of the battery, or the like. In one or more embodiments, the conditions for charging may be different than conditions for discharging of the battery. Optionally, the conditions for charging the battery and discharging the battery may be substantially the same.

In one or more embodiments, the processors may determine a surface temperature of the battery housing of the battery circuit based at least in part on the internal temperature of the battery. For example, the internal or core temperature of the battery may indicate the surface temperature of the battery. In one or more embodiments, the conditions for charging and/or discharging the battery may be based at least in part on the surface temperature of the battery housing.

At step 208, a decision is made whether the internal temperature of the battery exceeds a determined absolute threshold value. The determined absolute threshold value of the battery may be based on the type or modality of the battery, the age of the battery, operating conditions of the power control system (e.g., a length of time the system is in use, a length of time the system is not in use, or the like), environmental conditions of the environment in which the power control system is located, or the like. In one embodiment, the absolute threshold value may change responsive to the battery and/or the power system starting operation and/or stopping operation. In another embodiment, the absolute threshold value may change based on a change in operating conditions of the power control system. In another embodiment, the absolute threshold value may change responsive to an operating condition of the power control system and/or the battery circuit changing. If the core temperature of the battery exceeds the absolute threshold value, flow of the method proceeds toward step 212. Optionally, if the core or internal temperature of the battery is within a predetermined threshold range of the absolute threshold value (e.g., within 10% of the absolute value, within 5% of the absolute threshold value, or the like), flow of the method may proceed toward step 212. Alternatively, if the core or internal temperature of the battery does not exceed the absolute threshold value, or if the temperature of the battery is not within the predetermined threshold range of the absolute threshold value, flow of the method may proceed toward step 210.

At step 210, electric energy is automatically directed toward or away from the battery to charge or discharge the battery, respectively, based on the conditions for charging or discharging the battery. For example, charging electric energy 328 may be directed toward the battery for charging of the battery, and the conditions of the electric energy may include one or more of a charging current value, a charging voltage, a charging rate, or the like. Optionally, discharging electric energy 330 may be directed out of the battery, and the conditions may include a discharging current value, a discharging voltage, a discharging rate, or the like.

In one or more embodiments, the battery may automatically be charged or discharged at a rate of charging or discharging of the battery based on the conditions determined for charging the battery. In one or more embodiments, the battery should be automatically charged and/or discharged based on a type of charging or discharging of the battery (e.g., a trickle-charging or discharging mode, a pulsed-charging or discharging mode, or the like). Optionally, the battery may be automatically charged or discharged until the battery reaches a target state-of-charge, may be charged or discharged based on the state-of-charge of the battery, until the battery reaches a target total charge value, until the battery reaches an upper or lower charging capacity that the battery is capable of holding, or the like. Optionally, the charging and/or discharging of the battery may be distributed across a bank of batteries or battery circuits.

In one or more embodiments, the battery may be automatically charged by receiving electric energy from a power source that is external to the power control system, by receiving electric energy from an alternative internal power source (e.g., electric energy generated by a tractive motor or alternator of the power control system or an alternative energy storage device of the power control system via a power cable), by receiving electric energy via a utility grid through a catenary or third rail external to the power control system, by receiving electric energy from a wireless power transfer system, or the like.

In one or more embodiments, the battery may be automatically discharged by directing some electric energy from the battery towards a load of the power control system. For example, the battery may power propulsion loads 318 of the power control system, non-propulsion loads 320 of the power control system, other loads of the power control system, loads of another power control system, or the like. Optionally, power may be directed towards an energy storage device of the power control system, toward a power source that is external to the power control system, toward a ground or grounding circuit of the power control system, or the like.

At step 212, an alert may be communicated responsive to determining that the temperature of the battery exceeds the determined absolute threshold value. For example, an alert may be communicated to an operator onboard or proximate to the power control system, to an operator off-board the power control system, to a dispatch or control center disposed a distance away from the power control system, or the like. The alert may include notification of the temperature exceeding the determined absolute threshold value, instructions for actions to take based on a difference between the determined temperature and the absolute threshold value, an indication or notification that the processors have or will automatically change one or more operating conditions of the power control system, or the like.

In one or more embodiments, at step 214, one or more conditions for charging and/or discharging the battery may be changed. For example, the charging current value may be changed, the charging voltage may be changed, the rate of charging or discharging may change (e.g., to a faster rate or slower rate) may be changed, the total amount of electric energy that is being discharged or added to the battery for charging may change (e.g., increase or decrease), or the like. The change of the condition may be based on the difference between the determined temperature and the absolute threshold value, based on one or more of the current value or voltage of the battery changing, based on an operating condition of the power control system changing, or the like. At step 216, the battery is automatically charged and/or discharged based on the new conditions for charging and/or discharging the battery.

In one or more embodiments, the flowchart may repeat or continue while the battery and/or the power control system is operating. Optionally, the steps may continue at a determined, or predetermined, frequency (e.g., once every hour of operation the power control system, once every 24 hours of operation, based on a predetermined watt-hour usage of the battery, or the like). Optionally, the steps may continue based on the state-of-charge of the battery reaching predetermined charge limits (e.g., responsive to 75% of the total capacity of the battery remaining, responsive to 50% of the total capacity of the battery remaining, or the like). Optionally, the steps may continue or repeat responsive to manual intervention by an operator of the power control system (e.g., onboard or off-board) manually directing the processors to determine the internal temperature of the battery.

In one or more embodiments, the processors may receive the ambient temperature from a location adjacent to the power control system and the current value and voltage of the battery to determine the temperature of the battery. The processors may also receive actual internal battery temperature data, such as from a battery temperature sensor. Optionally, the processors may receive actual battery surface temperature data from the battery temperature sensor. The processors may verify the actual battery temperature data by comparing the actual battery temperature data with the determined temperature data. For example, the processors may verify the determined internal temperature of the battery by comparing the determined internal temperature of the battery with the actual internal temperature data, or verify the determined battery surface temperature by comparing the determined battery surface temperature with the actual battery surface temperature data.

In one embodiment, the processors may communicate an alert to an operator of the power control system based on a difference between the actual battery temperature and the determined temperature of the battery exceeding an upper limit determined relative threshold value. Optionally, the processors may communicate an alert based on the differences being below a lower limit determined relative threshold value. Optionally, the processors may change one or more variables or functions of an algorithm for determining the temperature of the battery based on the differences between the actual and determined temperature values.

In one or more embodiments of the subject matter described herein, a method includes receiving an ambient temperature adjacent to a system, an electric current value of electricity that is conducted into or out of a battery coupled with the system, and a voltage of a battery circuit that includes the battery. An internal temperature of the battery is determined based at least in part on the ambient temperature, the current value, and the voltage. One or more conditions for at least one of charging or discharging the battery are determined based at least in part on the internal temperature of the battery, the current value, and the voltage. The battery is at least one of charged or discharged based on least on the one or more conditions.

Optionally, the internal temperature of the battery may be determined without using a battery temperature sensor. Optionally, a surface temperature of a housing of the battery may be determined based at least in part on the internal temperature of the battery. The surface temperature may differ from the internal temperature. Optionally, the one or more conditions for charging or discharging of the battery may also be based on the surface temperature of the housing of the battery. Optionally, the one or more conditions may include one or more of a charging current value or a charging voltage of the battery. Optionally, the charging or discharging of the batter may include controlling a rate of the charging or discharging of the battery based on the one or more conditions. Optionally, internal battery temperature data may be received from a battery temperature sensor, and the internal temperature of the battery that is determined may be verified by comparing the battery temperature with the internal temperature of the battery that is determined.

Optionally, an alert may be communicated to an operator of the system based on a difference between the internal battery temperature data and the internal temperature of the battery that is determined exceeding a designated relative threshold value. Optionally, it may be determined that the internal temperature of the battery exceeds a designated absolute threshold value, and an alert may be communicated to an operator of the system based on the internal temperature of the battery exceeding the designated absolute threshold value. Optionally, one or more conditions for the charging or discharging the battery may be changed based on the internal temperature of the battery exceeding the designated absolute threshold.

In one or more embodiments of the subject matter described herein, a power control system includes a controller that includes one or more processors configured to receive an ambient temperature via a temperature sensor, an electric current value of electricity that is conducted into or out of a battery via a current sensor, and a voltage of a battery circuit that includes the battery via a voltage sensor. The processors may determine an internal temperature of the battery based on at least in part on the ambient temperature, the current value, and the voltage. The processors may determine one or more conditions for at least one of charging or discharging the battery based at least in part on the internal temperature of the battery, the current value, and the voltage. The processors may control the at least one of the charging or discharging of the battery based on the one or more conditions.

Optionally, the processors may determine the internal temperature of the battery without using a battery temperature sensor. Optionally, the processors may determine a surface temperature of a housing of the battery based on the internal temperature of the battery. The processors may determine the one or more conditions for charging or discharging the battery based on the surface temperature of the housing of the battery. Optionally, the one or more conditions may include one or more of a charging current value or a charging voltage of the battery. Optionally, the processors may control a rate of the charging or discharging of the battery based on the one or more conditions. Optionally, the system may include a battery temperature sensor that provides internal battery temperature data to the processors. The processors may verify the internal temperature of the battery that is determined by comparing the internal temperature data with the internal temperature of the battery that is determined. Optionally, a communication system may communicate an alert to an operator of the system based on a difference between the internal battery temperature data and the internal temperature of the battery that is determined exceeding a designated relative threshold value. Optionally, the processors may determine that the internal temperature of the battery that is determined exceeds a designated absolute threshold value, and may communicate an alert to an operator of the system responsive to determining that the internal temperature of the battery exceeds the designated absolute threshold value. Optionally, the processors may change the one or more of the one or more conditions for charging or discharging the battery based on the internal temperature of the battery exceeding the designated absolute threshold value.

In one or more embodiments of the subject matter described herein, a method includes receiving an ambient temperature of a system, an electric current value of electricity that is conducted into or out of a battery coupled with the system, and a voltage of the battery. An internal temperature of the battery may be determined without a battery temperature sensor. The internal temperature of the battery may be determined based at least in part on the ambient temperature, the current value, and the voltage. One or more conditions for charging the battery may be determined based at least in part on the internal temperature of the battery, the current value, and the voltage. The one or more conditions may include one or more of a charging current or a charging voltage of the battery. The one or more conditions may control a rate of charging of the battery. The battery is automatically charged based on the one or more conditions. It may be determined that the internal temperature of the battery exceeds a designated absolute threshold value, and an alert may be communicated to an operator of the system based on the internal temperature of the battery exceeding the designated absolute threshold value. One or more of the conditions for charging the battery may be changed based on the internal temperature of the battery exceeding the designated absolute threshold value.

According to another aspect, where a system includes a battery temperature sensor, the system may be configured to perform one or more of the various functions described herein (e.g., determine one or more conditions for charging and/or discharging the battery based at least in part on an estimated internal temperature of the battery) responsive to one or more of (i) the battery temperature sensor failing or otherwise entering a state where the battery temperature sensor is deemed unable to sense the internal battery temperature or provide data of the sensed internal battery temperature, (ii) the presence, generation, or receipt of a fail or fault flag or data, e.g., in a log/memory, indicative of a possible condition of the battery temperature sensor where the battery temperature sensor may not be providing reliable data of sensed internal batter temperature, (iii) a determination that data provided from the battery temperature sensor may be indicative of a faulty sensor, e.g., the data meets one or more designated criteria indicative of the data being potentially not accurately representative of the internal battery temperature, such as a value that is extremely low relative to ambient, or erratic temperature data where the data suggests a rapidly changing, up and down temperature (as is unlikely to occur in operation of a vehicle or other system); (iv) no data is received from the battery temperature sensor; (v) etc. The system may be configured such that it performs the one or more of the various functions described herein only responsive to one or more of the aforementioned conditions, e.g., controlling battery charging/discharging based on estimated internal temperature is only carried out if it is determined that data from an internal battery temperature sensor is unreliable or non-existent per designated criteria, as a backup or failsafe in the event of sensor failure.

In one embodiment, the controllers or systems described herein may have a local data collection system deployed that may use machine learning to enable derivation-based learning outcomes. The controllers may learn from and make decisions on a set of data (including data provided by the various sensors), by making data-driven predictions and adapting according to the set of data. In embodiments, machine learning may involve performing a plurality of machine learning tasks by machine learning systems, such as supervised learning, unsupervised learning, and reinforcement learning. Supervised learning may include presenting a set of example inputs and desired outputs to the machine learning systems. Unsupervised learning may include the learning algorithm structuring its input by methods such as pattern detection and/or feature learning. Reinforcement learning may include the machine learning systems performing in a dynamic environment and then providing feedback about correct and incorrect decisions. In examples, machine learning may include a plurality of other tasks based on an output of the machine learning system. In examples, the tasks may be machine learning problems such as classification, regression, clustering, density estimation, dimensionality reduction, anomaly detection, and the like. In examples, machine learning may include a plurality of mathematical and statistical techniques. In examples, the many types of machine learning algorithms may include decision tree based learning, association rule learning, deep learning, artificial neural networks, genetic learning algorithms, inductive logic programming, support vector machines (SVMs), Bayesian network, reinforcement learning, representation learning, rule-based machine learning, sparse dictionary learning, similarity and metric learning, learning classifier systems (LCS), logistic regression, random forest, K-Means, gradient boost, K-nearest neighbors (KNN), a priori algorithms, and the like. In embodiments, certain machine learning algorithms may be used (e.g., for solving both constrained and unconstrained optimization problems that may be based on natural selection). In an example, the algorithm may be used to address problems of mixed integer programming, where some components restricted to being integer-valued. Algorithms and machine learning techniques and systems may be used in computational intelligence systems, computer vision, Natural Language Processing (NLP), recommender systems, reinforcement learning, building graphical models, and the like. In an example, machine learning may be used making determinations, calculations, comparisons and behavior analytics, and the like.

In one embodiment, the controllers may include a policy engine that may apply one or more policies. These policies may be based at least in part on characteristics of a given item of equipment or environment. With respect to control policies, a neural network can receive input of a number of environmental and task-related parameters. These parameters may include, for example, operational input regarding operating equipment, data from various sensors, location and/or position data, and the like. The neural network can be trained to generate an output based on these inputs, with the output representing an action or sequence of actions that the equipment or system should take to accomplish the goal of the operation. During operation of one embodiment, a determination can occur by processing the inputs through the parameters of the neural network to generate a value at the output node designating that action as the desired action. This action may translate into a signal that causes the vehicle to operate. This may be accomplished via back-propagation, feed forward processes, closed loop feedback, or open loop feedback. Alternatively, rather than using backpropagation, the machine learning system of the controller may use evolution strategies techniques to tune various parameters of the artificial neural network. The controller may use neural network architectures with functions that may not always be solvable using backpropagation, for example functions that are non-convex. In one embodiment, the neural network has a set of parameters representing weights of its node connections. A number of copies of this network are generated and then different adjustments to the parameters are made, and simulations are done. Once the output from the various models are obtained, they may be evaluated on their performance using a determined success metric. The best model is selected, and the vehicle controller executes that plan to achieve the desired input data to mirror the predicted best outcome scenario. Additionally, the success metric may be a combination of the optimized outcomes, which may be weighed relative to each other.

As used herein, the terms "processor" and "computer," and related terms, e.g., "processing device," "computing device," and "controller" may be not limited to just those integrated circuits referred to in the art as a computer, but refer to a microcontroller, a microcomputer, a programmable logic controller (PLC), field programmable gate array, and application specific integrated circuit, and other programmable circuits. Suitable memory may include, for example, a computer-readable medium. A computer-readable medium may be, for example, a random-access memory (RAM), a computer-readable non-volatile medium, such as a flash memory. The term "non-transitory computer-readable media" represents a tangible computer-based device implemented for short-term and long-term storage of information, such as, computer-readable instructions, data structures, program modules and sub-modules, or other data in any device. Therefore, the methods described herein may be encoded as executable instructions embodied in a tangible, non-transitory, computer-readable medium, including, without limitation, a storage device and/or a memory device. Such instructions, when executed by a processor, cause the processor to perform at least a portion of the methods described herein. As such, the term includes tangible, computer-readable media, including, without limitation, non-transitory computer storage devices, including without limitation, volatile and non-volatile media, and removable and non-removable media such as firmware, physical and virtual storage, CD-ROMS, DVDs, and other digital sources, such as a network or the Internet.

The singular forms "a", "an", and "the" include plural references unless the context clearly dictates otherwise. "Optional" or "optionally" means that the subsequently described event or circumstance may or may not occur, and that the description may include instances where the event occurs and instances where it does not. Approximating language, as used herein throughout the specification and clauses, may be applied to modify any quantitative representation that could permissibly vary without resulting in a change in the basic function to which it may be related. Accordingly, a value modified by a term or terms, such as "about," "substantially," and "approximately," may be not to be limited to the precise value specified. In at least some instances, the approximating language may correspond to the precision of an instrument for measuring the value. Here and throughout the specification and clauses, range limitations may be combined and/or interchanged, such ranges may be identified and include all the sub-ranges contained therein unless context or language indicates otherwise.

This written description uses examples to disclose the embodiments, including the best mode, and to enable a person of ordinary skill in the art to practice the embodiments, including making and using any devices or systems and performing any incorporated methods. The clauses define the patentable scope of the disclosure, and include other examples that occur to those of ordinary skill in the art. Such other examples are intended to be within the scope of the claims if they have structural elements that do not differ from the literal language of the claims, or if they include equivalent structural elements with insubstantial differences from the literal language of the claims.

## Claims

1. A method comprising:
receiving an ambient temperature adjacent to a system, an electric current value of electricity that is conducted into or out of a battery coupled with the system, and a voltage of a battery circuit that includes the battery;
determining an internal temperature of the battery based at least in part on the ambient temperature, the current value, and the voltage;
determining one or more conditions for at least one of charging or discharging the battery based at least in part on the internal temperature of the battery, the current value, and the voltage; and
at least one of charging or discharging the battery based at least on the one or more conditions.

2. The method of claim 1, wherein the internal temperature of the battery is detemined without using a battery temperature sensor.

3. The method of claim 1, further comprising determining a surface temperature of a housing of the battery based at least in part on the internal temperature of the battery, the surface temperature differing from the internal temperature.

4. The method of claim 3, further comprising determining the one or more conditions for charging or discharging the battery based also on the surface temperature of the housing of the battery.

5. The method of claim 1, wherein the one or more conditions includes one or more of a charging current value or a charging voltage of the battery.

6. The method of claim 1, wherein the charging or discharging of the battery includes controlling a rate of the at least one of the charging or discharging of the battery based on the one or more conditions.

7. The method of claim 1, further comprising:
receiving internal battery temperature data from a battery temperature sensor; and
verifying the internal temperature of the battery that is determined by comparing the battery temperature data with the internal temperature of the battery that is determined.

8. The method of claim 7, further comprising communicating an alert to an operator of the system based on a difference between the internal battery temperature data and the internal temperature of the battery that is determined exceeding a designated relative threshold value.

9. The method of claim 1, further comprising
determining that the internal temperature of the battery exceeds a designated absolute threshold value; and
communicating an alert to an operator of the system based on the internal temperature of the battery exceeding the designated absolute threshold value.

10. The method of claim 9, further comprising changing the one or more conditions for charging or discharging the battery based on the internal temperature of the battery exceeding the designated absolute threshold value.

11. A power control system comprising:
a controller comprising one or more processors configured to receive an ambient temperature via a temperature sensor, an electric current value of electricity that is conducted into or out of a battery via a current sensor, and a voltage of a battery circuit that includes the battery via a voltage sensor,
the one or more processors configured to determine an internal temperature of the battery based at least in part on the ambient temperature, the current value, and the voltage,
the one or more processors configured to determine one or more conditions for at least one of charging or discharging the battery based at least in part on the internal temperature of the battery, the current value, and the voltage, and
the one or more processors configured to control at least one of charging or discharging of the battery based on the one or more conditions.

12. The power control system of claim 11, wherein the one or more processors are configured to determine the internal temperature of the battery without using a battery temperature sensor.

13. The power control system of claim 11, wherein the one or more processors are configured to determine a surface temperature of a housing of the battery based on the internal temperature of the battery, and determine the one or more conditions for charging or discharging the battery based on the surface temperature of the housing of the battery.

14. The power control system of claim 11, wherein the one or more conditions includes one or more of a charging current value or a charging voltage of the battery.

15. The power control system of claim 11, wherein the one or more processors are configured to control a rate of the at least one of charging or discharging of the battery based on the one or more conditions.
